# EUROPEAN PATENT APPLICATION

(11) **EP 1 930 799 A2**
(43) Date of publication of application: **11.06.2008**
(21) Application number: 07122270.7
(22) Date of filing: 04.12.2007
(51) Int. Cl.: G06F 1/18, H05K 5/02, E05C 1/10

(54) **Apparatus and method for holding a cover in a closed position**

(30) Priority: 04.12.2006 US 566536
(71) Applicant: TYCO ELECTRONICS POWER SYSTEMS, INC., Mesquite TX 75149 (US)
(72) Inventor: Kim, Min C., San Jose, CA 95129 (US); Nguyen, Khanh, Allen, TX 75002 (US); Haisler, Mark A., Dallas, TX 75238 (US)
(74) Representative: Johnstone, Douglas Ian

(57) **Abstract**

An apparatus for holding a cover (60) in a closed position substantially covering a chassis face (44) of a unit (40). The unit (40) contains equipment in an equipment volume (42) with the equipment volume (42) being partially bounded by the chassis face (44).
The apparatus includes: a positioning structure or hinge (52) coupling the cover (60) with the unit (40) for selectively situating the cover (60) in the closed position or in another position; and a latching structure (70) configured for latchingly engaging said chassis face (44) and said cover (60) for holding said cover (60) in said closed position when said latching structure (70) is in a first position or configuration. The latching structure (70) does not engage the chassis face (44) and the cover (60) when the latching structure (70) is in a second position or configuration. The latching structure (70) is situated substantially entirely outside the equipment volume (42).

## Description

The present invention is directed to equipment containing units, and especially to equipment containing containers having a cover movable from an open position or orientation to a latched closed or operational position or orientation.

Typical prior art mechanisms employed with equipment unit covers include a latching mechanism that is in a latched position during normal operation of the unit. A latching spring or similar latching bias member is employed to hold the latch in a latched position until an operator applies a releasing force to the latching mechanism to overcome the bias of the latching spring and move the latching mechanism away from the latched position. Once the releasing force is removed, the latching mechanism responds to force applied by the latching bias member and returns to its latched position. This latching arrangement requires the latching mechanism and the latching spring to be held in proper relative positions with each other and with the equipment unit while still permitting free movement of the latching mechanism into and out of the latched positions.

There is a need for a method and apparatus that provide improved holding of a latching mechanism and latching bias member with respect to an equipment unit and with respect to each other.

The solution is provided by an apparatus for latching a cover into a closed orientation or position with respect to a unit. The unit contains equipment within a volume and presents a chassis face towards the cover with the cover generally in register with the chassis face in the closed orientation. The cover is rotatably affixed with the unit at a first end for swinging movement between an open orientation or position and the closed position. The apparatus comprising: an engaging structure and a biasing structure. The engaging structure and the biasing structure being substantially entirely situated between the chassis face and the cover in the closed position. The engaging structure and the biasing structure cooperate to orient or position the engaging structure for holding the cover in the closed position when the engaging structure and the biasing structure are in a first position. The engaging structure and the biasing structure cooperate to release the holding of the cover when the engaging structure and the biasing structure are in a second orientation or position.

The solution is also provided by an apparatus for holding a cover in a closed position substantially covering a chassis face of a unit. The unit contains equipment in an equipment volume. The equipment volume is partially bounded by the chassis face. The apparatus comprising: a positioning structure coupling the cover with the unit for selectively situating the cover in the closed position or in another position; and a latching structure configured for latchingly engaging the chassis face and the cover for holding the cover in the closed position when the latching structure is in a first position. The latching structure does not engage or interconnect the chassis face and the cover when the latching structure is in a second position. The latching structure is situated substantially entirely outside the equipment volume.

The solution is also provided by a method for holding a cover in a closed position substantially covering a chassis face of a unit. The unit contains equipment in an equipment volume. The equipment volume is partially bounded by the chassis face. The method comprising: (a) in no particular order: (1) providing a positioning structure coupling the cover with the unit for selectively situating the cover in the closed position or in another position; and (2) providing a latching structure configured for latchingly engaging the chassis face and the cover for holding the cover in the closed position when the latching structure is in a first position; the latching structure not engaging the chassis face and the cover when the latching structure is in a second position; the latching structure being situated substantially entirely outside the equipment volume; (b) situating the cover in the closed position; and (c) positioning the latching structure in the first position.

The invention will now be described by way of example with reference to the accompanying drawings in which:
FIG. 1 is a perspective view of a portion of an equipment unit equipped with a prior art cover latch, with the cover in an open position;
FIG. 2 is a perspective partially exploded view of the equipment unit illustrated in FIG. 1;
FIG. 3 is a perspective view of a portion of an equipment unit equipped with a first embodiment of a cover latch configured according to the teachings of the present invention, with the cover in an open position;
FIG. 4 is a perspective partially exploded view of the equipment unit illustrated in FIG. 3;
FIG. 5 is a perspective view of a latching apparatus configured according to a second embodiment of the present invention;
FIG. 6 is a perspective view of a portion of an equipment unit equipped with the second embodiment of a cover latch illustrated in FIG. 5, with the cover in an open position; and
FIG. 7 is a flow chart illustrating the method of the present invention.

The present invention is directed to a method and apparatus that provide improved holding of a latching mechanism and latching bias member with respect to an equipment unit and with respect to each other using a single unitary structure. Such an apparatus is therefore less expensive to manufacture. Further, such a unitary structure would be more reliable in operation than a multi-piece structure which satisfies the required functions of housing and latching a latching bias member for the latching mechanism and is appropriate for permitting the required one degree of freedom required for moving the latching mechanism into and out of a latched position.

It is, therefore an object of the present invention to provide a method and apparatus that provide improved holding of the latching mechanism and latching bias member with respect to the equipment unit and with respect to each other using a single unitary structure. The present invention is further advantageously configured for installation and operation substantially outside the equipment volume of the unit, thereby providing additional room for equipment.

It is another object of the present invention to provide a positioning bias member for urging the cover away from an operational or closed position toward an open position.

It is yet another object of the present invention to provide a unitary structure that functions as a latching member housing and acts as a latching member bias member as well as providing a positioning bias member for urging the cover away from an operational or closed position towards an open position.

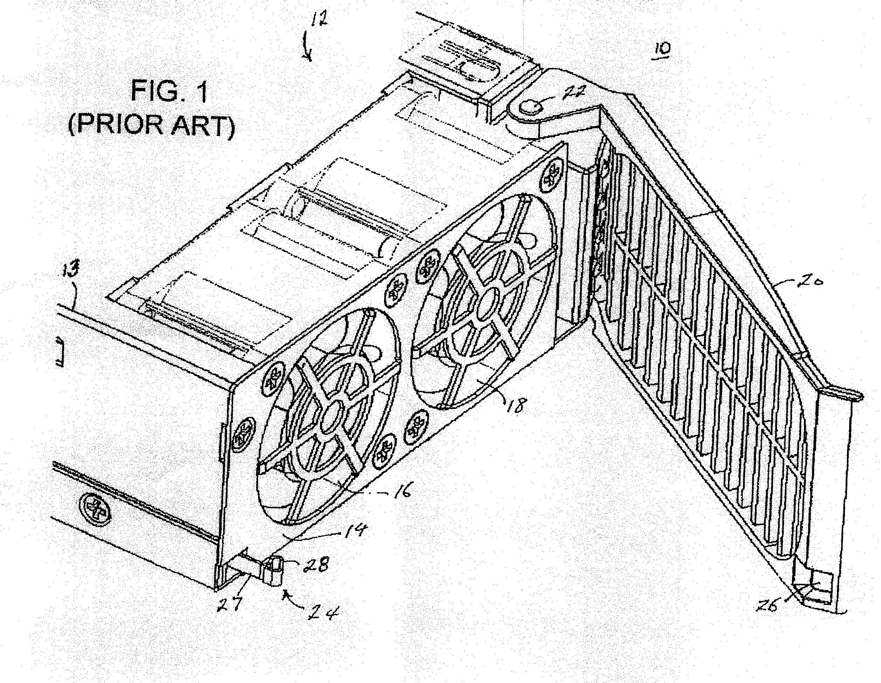

FIG. 1 is a perspective view of a portion of an equipment unit equipped with a prior art cover latch, with the cover in an open position. In FIG. 1, an equipment unit 10 includes an equipment volume 12 defined in part by a cabinet 13 (shown in part in FIG. 1). Equipment is not illustrated in detail in FIG. 1. However, one skilled in the art of equipment design will recognize that various kinds of equipment may be installed in the equipment volume 12. By way of example and not by way of limitation, the equipment unit 10 is representatively illustrated in FIG. 1 as an electrical rectifier unit of the sort employed in the communication industry.

The equipment volume 12 is bounded at one end of the cabinet 13 by a chassis face 14. The chassis face 14 is provided with vent structures 16, 18 for accommodating air flow into or out of equipment volume 12 for cooling equipment contained in the equipment volume 12 (not shown in FIG. 1). A cover 20 is provided for covering the chassis face 14. The cover 20 is rotatably coupled with cabinet 13 by a hinge structure 22 to permit swinging orientation of the cover 20 about hinge structure 22 between an open position (illustrated in FIG. 1) and a closed position with the cover 20 substantially abutting the chassis face 14 and substantially in register with the chassis face 14.

A latch 24 is provided in an extended position generally perpendicular to the chassis face 14. A latch receiving aperture 26 is provided in the cover 20 in a location that places the latch receiving aperture 26 substantially in register with the latch 24 when the cover 20 is in a closed position. The latch 24 is configured with a flexible arm 27 extending from the chassis face 14. An engaging structure 28 is located at an end of the flexible arm 27 distal from the chassis face 14. As the cover 20 is urged (by a user or operator) from an open position towards a closed position, engaging structure 28 comes into contact with the receiving aperture 26. As the cover 20 is further urged towards the closed position, the flexible arm 27 is flexed to permit the engaging structure 28 to move from an at-rest position to a flexed position as the engaging structure 28 passes through the receiving aperture 26. The length of the flexible arm 27 is appropriate to permit the engaging structure 28 to pass through the receiving aperture 26 and substantially return towards its at-rest position to a latching position that is preferably between its at-rest position and its flexed position once the engaging structure 28 passes through the receiving aperture 26. The length of the flexible arm 27 is appropriate to hold the cover 20 in its closed position substantially in register with the chassis face 14 and substantially abutting the chassis face 14 with the engaging structure 28 (in its latching position) interfering with or preventing movement of the cover 20 away from its closed position. To move the cover 20 from its closed position, a user may apply a clearing force to the engaging structure 28 to flex the flexible arm 27 sufficiently to move the engaging structure 28 to a clearance position where it can clear and pass through the receiving aperture 26. Once the engaging structure 28 is in such a clearance position, the user may apply a moving force to the cover 20 to urge the cover 20 away from the chassis face 22 while still maintaining the clearance position of the engaging structure 28. When the receiving aperture 26 clears the engaging structure 28, the user may relax the clearing force, the flexible arm 27 is relaxed and the engaging structure 28 returns to its at-rest position. The user may continue to apply the moving force to further rotatably move the cover 20 towards an open position.

One disadvantage associated with the latch 24 is that it requires mounting within the equipment volume 12, thereby occupying space that could be used for the equipment installation, space that could be used to enhance air flow within the equipment volume 12 to improve cooling of equipment, or space that could be employed for other purposes.

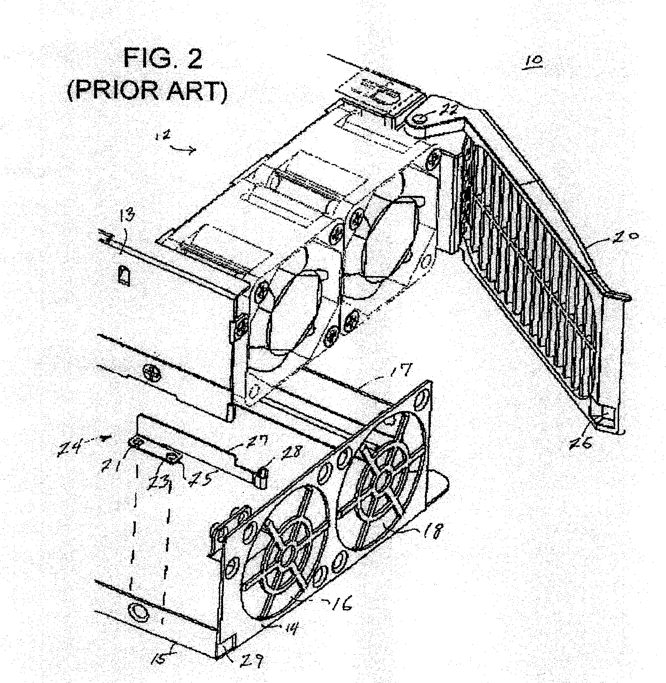

FIG. 2 is a perspective partially exploded view of the equipment unit illustrated in FIG. 1. In FIG. 2, equipment unit 10 includes the cabinet 13 (shown in part in FIG. 2) contributing to defining the equipment volume 12. The chassis face 14 is illustrated in exploded relation with respect to the cabinet 13. The chassis face 14 is coupled with the chassis members 15, 17. The cover 20 is rotatably coupled with the cabinet 13 by the hinge structure 22 to permit swinging movement of the cover 20 about the hinge structure 22 between an open position (illustrated in FIG. 2) and a closed position with the cover 20 substantially abutting the chassis face 14 and substantially in register with the chassis face 14.

Latch 24 is illustrated in exploded relation with respect to the chassis face 14. The latch 24 may be coupled with the chassis member 15 by the support portion 25. The support portion 25 is illustrated in FIG. 2 as having attachment apertures 21, 23 configured appropriately to effect mounting of the latch 24 with the chassis member 15 using screws or rivets (not shown in FIG. 2). Other mounting techniques may alternatively be employed for attaching the latch 24 with the chassis member 15 including, by way of example and not by way of limitation, welding, soldering, adhesive and forming the latch member 24 integrally with the chassis member 15.

The latch 24 is mounted with the chassis member 15 in a position to permit the latch 24 to extend through the latch aperture 29 in the chassis face 14 an appropriate distance to permit cooperation between the latch 24 and the cover 20 when moving the cover 20 between the open position and a closed position as described above in connection with FIG. 1. In order to avoid prolixity, that operation will not be described again here.

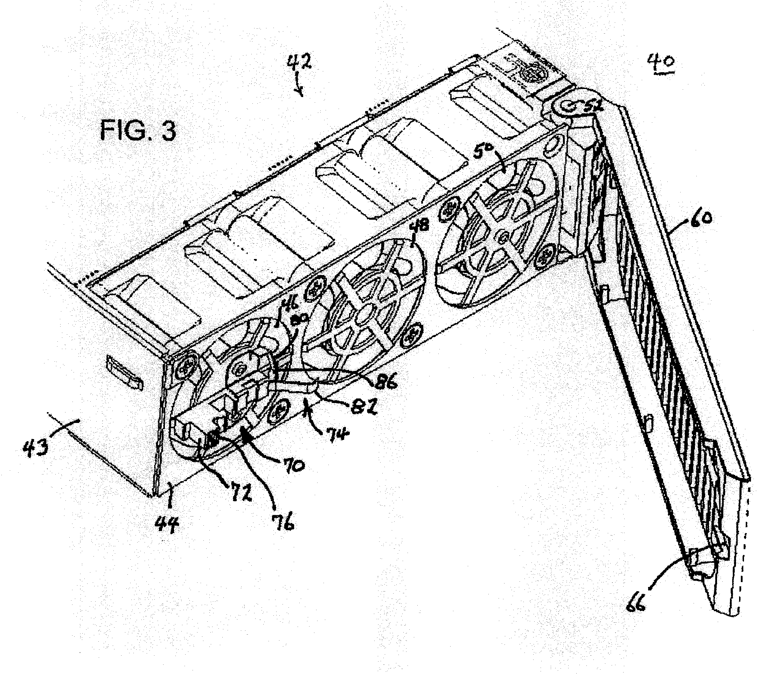

FIG. 3 is a perspective view of a portion of an equipment unit equipped with a first embodiment of a cover latch configured according to the teachings of the present invention, with the cover in an open position. In FIG. 3, an equipment unit 40 includes an equipment volume 42 defined in part by a cabinet 43 (shown in part in FIG. 3). Equipment is not illustrated in detail in FIG. 3. However, one skilled in the art of equipment design will recognize that various kinds of equipment may be installed in the equipment volume 42. By way of example, and not by way of limitation, equipment unit 40 is representatively illustrated in FIG. 3 as an electrical rectifier unit of the sort employed in the communication industry.

The equipment volume 42 is bounded at one end of the cabinet 43 by a chassis face 44. The chassis face 44 is provided with vent structures 46, 48, 50 for allowing air flow into or out of the equipment volume 42 for cooling equipment contained in the equipment volume 42 (not shown in FIG. 3). A cover 60 is provided for covering the chassis face 44. The cover 60 is rotatably coupled with the cabinet 43 by a hinge structure 52 to permit swinging position or movement of the cover 60 about the hinge structure 52 between an open position (illustrated in FIG. 3) and a closed position with the cover 60 substantially abutting the chassis face 44 and substantially in register with the chassis face 44.

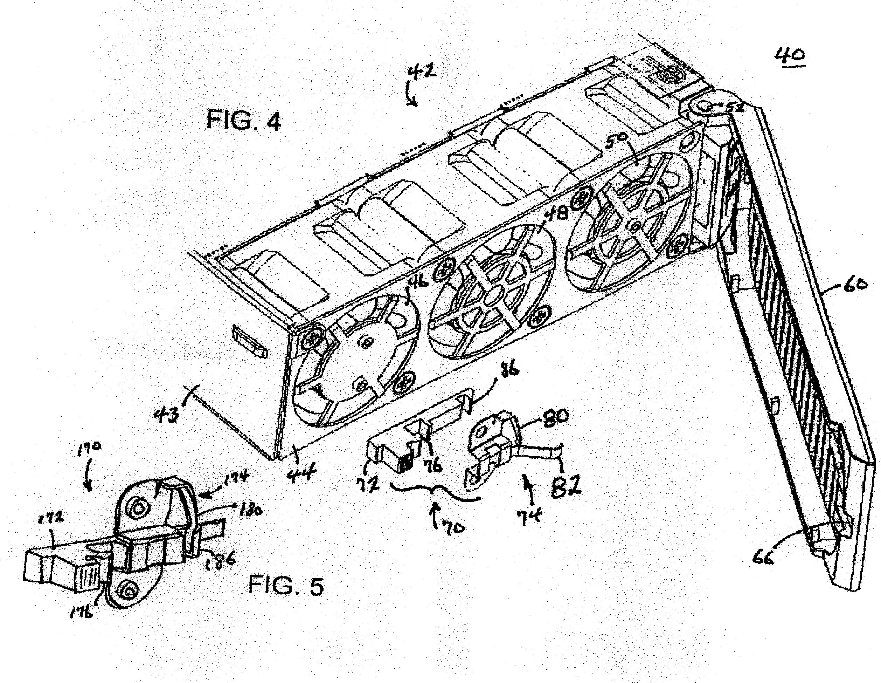

A latch assembly 70 is provided for holding the cover 60 in the closed position. The latch assembly 70 is a two piece assembly (see exploded view; FIG. 4) including an engaging structure 72 and a biasing structure 74. In the embodiment of the invention illustrated in FIG. 3 (and in FIG. 4) the biasing structure 74 is configured in a unitary structure including a latching bias member 80 for providing a latching bias force to the engaging structure 72 and including a positioning bias member 82 for providing a positioning bias force to urge the cover 60 towards an open orientation or position.

The biasing structure 74 is affixed with the chassis face 44 in a straddling captive arrangement or orientation with respect to the engaging structure 72 so as to permit the engaging structure 72 to move, preferably substantially along a single axis (i.e., with preferably substantially one degree of freedom) while being held captive by or between the biasing structure 74 and the chassis face 44. The latching bias member 80 bears against a wall 86 (or similar portion) of the engaging structure 72 to provide a biasing force resisting movement of the engaging structure 72 from an at-rest position. Positioning bias member 82 is oriented or configured to be moved from an unflexed configuration to a flexed configuration when the cover 60 is moved from its open position to its closed position. Positioning bias member 82 therefore applies a positioning bias force against the cover 60 urging the cover 60 away from its closed orientation or position when cover 60 is in its closed position.

Latch assembly 70 is installed in an orientation so as to position a latch structure 76 of the engaging structure 72 so that it extends in a direction pointing away from the chassis face 44 towards the cover 60. A latch receiving aperture 66 is provided in the cover 60 in a location that places the latch receiving aperture 66 substantially in register with the latch structure 76 when the cover 60 is in a closed orientation or position. As the cover 60 is urged (by a user or operator) away from an open position towards the a closed position, the latch aperture 66 comes into contact with the latch structure 76. As the cover 60 is further urged toward the closed position, the engaging structure 72 is urged against a bias exerted by the biasing structure 74 to permit the latch structure 76 to move from an at-rest position to a flexed position as the latch structure 76 passes through receiving the aperture 66. The latch structure 76 extends an appropriate distance from the chassis face 44 to permit the latch structure 76 to pass through the receiving aperture 66 and substantially return towards its at-rest position to a latching position that is preferably between its at-rest position and its flexed position once the latch structure 76 has passed through the receiving aperture 66. The reach of the latch structure 76 from the chassis face 44 is preferably appropriate to hold the cover 60 in its closed orientation and substantially in register with the chassis face 44 and substantially abutting the chassis face 44 with the latch structure 76 (in its latching position) resisting or interfering with movement of cover the 60 away from its closed position.

To move the cover 60 from its closed position, a user must apply a clearing force to the latch structure 76 to flex the latching bias member 80 sufficiently to move the latch structure 76 to an appropriate clearance position to clear and pass through the receiving aperture 66. Once the latch structure 76 is in its clearance position, a positioning bias force provided by the positioning bias member 82 will urge the cover 60 away from the chassis face 44. When the receiving aperture 66 clears the latch structure 76, the user may relax the clearing force, releasing the latching bias member 80 so that the latch structure 76 returns to its at-rest position.

One advantage associated with the latch assembly 70 is that it is mounted entirely outside of the equipment volume 42 thereby leaving available space that may be advantageously employed for equipment installation, employed to enhance air flow within the equipment volume 12 to improve cooling of equipment, or be employed for other purposes.

FIG. 4 is a perspective partially exploded view of the equipment unit illustrated in FIG. 3. In FIG. 4, the equipment unit 40 includes the equipment volume 42 defined in part by the cabinet 43 (shown in part in FIG. 4). The equipment volume 42 is bounded at one end of the cabinet 43 by the chassis face 44. The cover 60 is rotatably coupled with the cabinet 43 by the hinge structure 52 to permit swinging movement of the cover 60 about the hinge structure 52 between an open position (illustrated in FIG. 4) and a closed position with cover 60 substantially abutting the chassis face 44 and substantially in register with the chassis face 44.

The latch assembly 70 is illustrated in FIG. 4 in an exploded state. The latch assembly 70 includes the engaging structure 72 and the biasing structure 74. The biasing structure 74 is configured as a unitary structure including the latching bias member 80 for providing a latching bias force to the engaging structure 72 and includes positioning bias member 82 for providing a positioning bias force to urge the cover 60 towards an open position.

The biasing structure 74 is illustrated in FIG. 4 in an exploded state ready for assembly with the chassis face 44 in a straddling captive configuration with respect to the engaging structure 72 so as to permit the engaging structure 72 to move, preferably substantially along a single axis (i.e., with preferably substantially one degree of freedom). The engaging structure 72 is held captive by the biasing structure 74 in cooperation with the chassis face 44. The latching bias member 80 bears against the wall 86 of the engaging structure 72 to provide a biasing force resisting movement of the engaging structure 72 away from its at-rest position. The latching bias member 80 may bear against another portion of the engaging structure 72 if desired. The positioning bias member 82 is positioned to be moved from an unflexed position to a flexed position when the cover 60 is moved from its open position to its closed position. Positioning bias member 82 therefore applies a positioning bias force against the cover 60 urging the cover 60 away from its closed position when the cover 60 is in its closed position.

The latch assembly 70 includes the latch structure 76 extending in a direction away from the chassis face 44 towards the cover 60 when the latch assembly 70 is installed on chassis face 44. The latch receiving aperture 26 is provided in the cover 60 in a location substantially in register with the latch structure 76 when the cover 60 is in its closed position. As the cover 60 is urged (by a user or operator) from its open position towards its closed position, the latch aperture 66 cooperates with the latch structure 76 to effect latching of the cover 60 in a closed position, as described above in connection with FIG. 3.

FIG. 5 is a perspective view of a latching apparatus configured according to a second embodiment of the present invention. In FIG. 5, a latch assembly 170 is shown which is a two piece assembly including an engaging structure 172 and a biasing structure 174. The biasing structure 174 is configured as a unitary structure including a latching bias member 180 for providing a latching bias force to the engaging structure 172. The biasing structure 174 does not include an integral positioning bias member as in the first embodiment described.

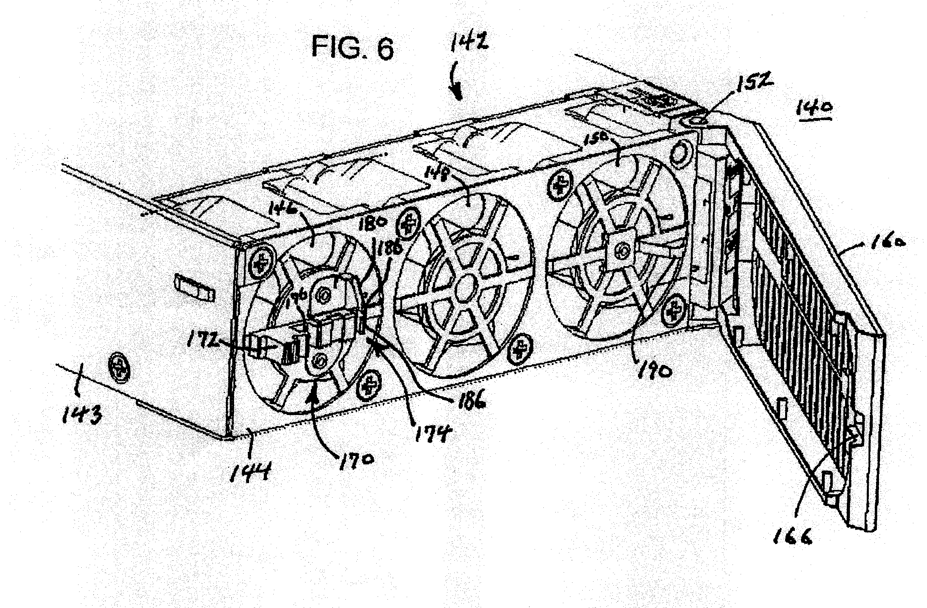

The biasing structure 174 is affixed with or to a chassis face 144 (see FIG. 6) in a straddling captive configuration with respect to the engaging structure 172 so as to permit the engaging structure 172 to move, preferably substantially along a single axis (i.e., with preferably substantially one degree of freedom) while being held captive between or by the biasing structure 174 and the chassis face 144. The latching bias member 180 bears against a wall 186 (or similar portion) of the engaging structure 172 to provide a biasing force resisting movement of the engaging structure 172 from an at-rest position. The latch assembly 70 is installed in an orientation or position illustrated in FIG. 6.

FIG. 6 is a perspective view of a portion of an equipment unit equipped with the second embodiment of the cover latch illustrated in FIG. 5, with the cover in an open position. In FIG. 6, an equipment unit 140 includes an equipment volume 142 defined in part by a cabinet 143 (shown in part in FIG. 6). Equipment is not illustrated in detail in FIG. 6. However, one skilled in the art of equipment design will recognize that various kinds of equipment may be installed in equipment volume 142. By way of example and not by way of limitation, the equipment unit 140 is representatively illustrated in FIG. 6 as an electrical rectifier unit of the sort employed in the communication industry.

The equipment volume 142 is bounded at one end of the cabinet 143 by a chassis face 144. The chassis face 144 is provided with vent structures 146, 148, 150 for accommodating air flow into or out of the equipment volume 142 for cooling equipment contained in the equipment volume 142 (not shown in FIG. 6). A cover 160 is provided for covering the chassis face 144. The cover 160 is rotatably coupled with the cabinet 143 by a hinge structure 152 to permit swinging movement of the cover 160 about the hinge structure 152 between an open position (illustrated in FIG. 6) and a closed position with cover 160 substantially abutting the chassis face 144 and substantially in register with the chassis face 144.

The latch assembly 170 is provided for holding the cover 160 in its closed position. The latch assembly 170 is a two piece assembly (see exploded view; FIG. 5) including the engaging structure 172 and the biasing structure 174. In the embodiment of the invention illustrated in FIG. 6 (and in FIG. 5) the biasing structure 174 is configured as a unitary structure including the latching bias member 180 for providing a latching bias force to the engaging structure 172.

A positioning bias member 190 is affixed with or to the chassis face 144 at a position remote from the latching assembly 170. In the exemplary embodiment illustrated in FIG. 6, the positioning bias member 190 is affixed to the chassis face 144 in the vicinity of the vent structure 150. Alternatively, by way of example and not by way of limitation, the positioning bias member 190 may be affixed to chassis face 144 in the vicinity of the vent structure 148 or elsewhere on chassis face 144 so long as the positioning bias member 190 provides a positioning bias force to urge the cover 160 towards an open position when the cover 160 is in its closed position. Preferably, positioning bias member 190 is arranged to be moved from an unflexed position to a flexed position when the cover 160 is moved from its open position to its closed position. The positioning bias member 190 therefore applies a positioning bias force against the cover 160 urging the cover 160 away from its closed position when the cover 160 is in its closed position.

The biasing structure 174 is affixed to the chassis face 144 in a straddling captive position with respect to the engaging structure 172 so as to permit the engaging structure 172 to move, preferably substantially along a single axis (i.e., with preferably substantially one degree of freedom) while being held captive by the biasing structure 174 and the chassis face 144. The latching bias member 180 bears against a wall 186 (or similar portion) of the engaging structure 172 to provide a biasing force resisting movement of the engaging structure 172 from an at-rest position.

The latch assembly 170 is installed in an orientation so as to position a latch structure 176 of the engaging structure 172 so that it extends in a direction away from chassis face 144 towards the cover 160. A latch receiving aperture 166 is provided in the cover 160 in a location that places the latch receiving aperture 166 substantially in register with the latch structure 176 when the cover 160 is in its closed position. As the cover 160 is urged (by a user or operator) from its open position towards its closed position, the latch aperture 166 comes into contact with the latch structure 176. As the cover 160 is further urged toward its closed position, the engaging structure 172 is urged against a bias exerted by the biasing structure 174 to permit the latch structure 176 to move from an at-rest position to a flexed position as the latch structure 176 passes through the receiving aperture 166. The latch structure 176 extends an appropriate distance from the chassis face 144 to permit the latch structure 176 to pass through the receiving aperture 166 and substantially return towards its at-rest position to a latching position that is preferably between its at-rest position and its flexed position once the latch structure 176 passes through the receiving aperture 166. The reach of the latch structure 176 from the chassis face 144 is preferably appropriate to hold the cover 160 in its closed position substantially in register with the chassis face 144 and substantially abutting the chassis face 144 with the latch structure 176 (in its latching position) resisting or interfering with movement of the cover 160 away from its closed position.

To move the cover 160 from its closed position, a user must apply a clearing force to the latch structure 176 to flex the latching bias member 180 sufficiently to move the latch structure 176 to a clearance position so that it can clear and pass through the receiving aperture 166. Once the latch structure 176 is in its clearance position, a positioning bias force provided by the positioning bias member 190 will urge the cover 160 away from the chassis face 144. When receiving aperture 166 clears the latch structure 176, the user may relax the clearing force, the latching bias member 180 is relaxed and the latch structure 176 returns to its at-rest position.

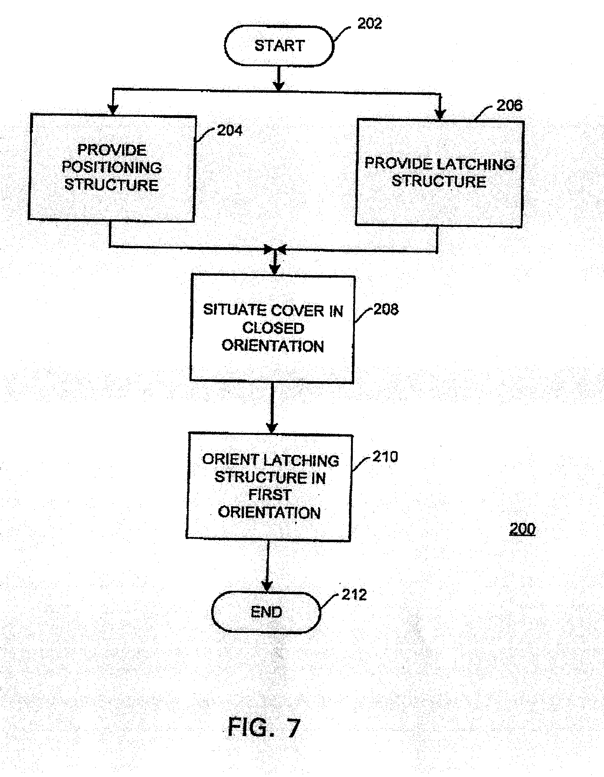

FIG. 7 is a flow chart illustrating the method of the present invention. In FIG. 7, a method 200 for holding a cover in a closed position substantially covering a chassis face of a unit begins at a START point 202. The unit contains equipment in an equipment volume. The equipment volume is partially bounded by the chassis face. Method 200 continues with, in no particular order: (1) providing a positioning structure coupling the cover with the unit for selectively situating the cover in the closed position or in an other orientation, as indicated by a block 204; and (2) providing a latching structure configured for latchingly engaging the chassis face and the cover for holding the cover in the closed orientation when the latching structure is in a first orientation, as indicated by a block 206. The latching structure does not engage the chassis face and the cover when the latching structure is in a second position. The latching structure is situated substantially entirely outside the equipment volume.

Method 200 continues by situating the cover in the closed orientation, as indicated by a block 208. Method 200 continues by positioning the latching structure in the first position, as indicated by a block 210. Method 200 terminates at an END point 212.

It is to be understood that, while the detailed drawings and specific examples given describe preferred embodiments of the invention, they are for the purpose of illustration only, that the apparatus and method of the invention are not limited to the precise details and conditions disclosed and that various changes may be made therein without departing from the scope of the invention which is defined by the following claims.

## Claims

1. An apparatus for latching a cover (60, 160) into a closed position with respect to a unit (40, 140); said unit (40, 140) containing equipment within a volume (42, 142) and having a chassis face (44, 144) facing towards said cover (60, 160) with said cover (60, 160) generally in register with said chassis face (44, 144) in said closed position; said cover (60, 160) being rotatably affixed with said unit (40, 140) at a first end for swinging movement between an open position and said closed position; the apparatus comprising: an engaging structure (72, 172) and a biasing structure (74, 174); said engaging structure (72, 172) and said biasing structure (74, 174) being substantially entirely situated between said chassis face (44, 144) and said cover (60, 160) in said closed position; and said engaging structure (72, 172) and said biasing structure (74, 174) cooperating to position said engaging structure (72, 172) for holding said cover (60, 160) in said closed position when said engaging structure (72, 172) and said biasing structure (74, 174) are in a first position or configuration; said engaging structure (72, 172) and said biasing structure (74, 174) cooperating to release said holding of said cover (60, 160) when said engaging structure (72, 172) and said biasing structure (74, 174) are in a second position or configuration.

2. An apparatus as recited in claim 1 wherein the apparatus further comprises a latching bias member (80, 180) coupled with at least one of said engaging structure (72, 172) and said biasing structure (74, 174); said latching bias member (80, 180) urging said engaging structure (72, 172) and said biasing structure (74, 174) toward said first position.

3. An apparatus as recited in claim 1 or 2 wherein the apparatus further comprises a positioning bias member (82, 190) coupled with at least one of said cover (60, 160), said chassis face (44, 144), said engaging structure (72, 172) and said biasing structure (74, 174); said positioning bias member (82, 190) urging said cover (60, 160) away from said closed position.

4. An apparatus as recited in claim 2 and 3 wherein said latching bias member (80) and said positioning bias member (82) are configured in a unitary bias member (74) coupled with at least one of said engaging structure (72), said chassis face (44) and said cover (60).

5. An apparatus for holding a cover (60, 160) in a closed position substantially covering a chassis face (44, 144) of a unit (40, 140); said unit (40, 140) containing equipment in an equipment volume (42, 142); said equipment volume (42, 142) being partially bounded by said chassis face (44, 144); the apparatus comprising: a positioning structure (52, 152) coupling said cover (60, 160) with said unit (40, 140) for selectively situating said cover (60, 160) in said closed position or in another position; and a latching structure (70, 170) configured for latchingly engaging said chassis face (44, 144) and said cover (60, 160) for holding said cover (60, 160) in said closed position when said latching structure (70, 170) is in a first position or configuration; said latching structure (70, 170) not engaging said chassis face (44, 144) and said cover (60, 160) when said latching structure (70, 170) is in a second position or configuration; said latching structure (70, 170) being situated substantially entirely outside said equipment volume (42, 142).

6. An apparatus as recited in claim 5 wherein said positioning structure (52, 152) is configured for effecting swinging movement of said cover (60, 160) with respect to said chassis face (44, 144) between said closed position and said other position.

7. An apparatus as recited in claim 5 or 6 wherein the apparatus further comprises a latching bias member (80, 180) coupled with at least one of said latching structure (70, 170), said cover (60, 160) and said chassis face (44, 144); said latching bias member (80, 180) urging said latching structure (70, 170) towards said first position.

8. An apparatus as recited in claim 5, 6 or 7 wherein the apparatus further comprises a positioning bias member (82, 190) coupled with at least one of said cover (60, 160), said chassis face (44, 144) and said latching structure (70, 170); said positioning bias member (82, 190) urging said cover (60, 160) away from said closed orientation.

9. An apparatus as recited in claim 5, 7 and 8 wherein said latching bias member (80, 180) and said positioning bias member (82, 190) are configured as a unitary bias member (74, 174) coupled with at least one of said latching structure (70, 170), said chassis face (44, 144) and said cover (60, 160).

10. A method for holding a cover (60, 160) in a closed position substantially covering a chassis face (44, 144) of a unit (40, 140); said unit (40, 140) containing equipment in an equipment volume (42, 142); said equipment volume (42, 142) being partially bounded by said chassis face (44, 144); the method comprising:
(a) in no particular order:
(1) providing a positioning structure (52, 152) coupling said cover (60, 160) with said unit (40, 140) for selectively situating said cover (60, 160) in said closed position or in another position; and
(2) providing a latching structure (70, 170) configured for latchingly engaging said chassis face (44, 144) and said cover (60, 160) for holding said cover (60, 160) in said closed position when said latching structure (70, 170) is in a first position or configuration; said latching structure (70, 170) not engaging said chassis face (44, 144) and said cover (60, 160) when said latching structure (70, 170) is in a second position or configuration; said latching structure (70, 170) being situated substantially entirely outside said equipment volume (42, 142);
(b) situating said cover (60, 160) in said closed position; and
(c) orienting said latching structure (70, 170) in said first position or configuration.

11. A method as recited in claim 10 wherein the method further comprises providing a latching bias member (80, 180) coupled with at least one of said latching structure (70, 170), said cover (60, 160) and said chassis face (44, 144); said latching bias member (80, 180) being oriented for urging said latching structure (70, 170) toward said first position or configuration.

12. A method as recited in claim 10 or 11 wherein the method further comprises providing a positioning bias member (82, 190) coupled with at least one of said cover (60, 160), said chassis face (44, 144) and said latching structure (70, 170); said positioning bias member (82, 190) being oriented for urging said cover (60, 160) away from said closed orientation.

13. A method as recited in claim 5, 11 and 12 wherein said latching bias member (80, 180) and said positioning bias member (82, 190) are configured in a unitary bias member (74, 174) coupled with at least one of said latching structure (70, 170), said chassis face (44, 144) and said cover (60, 160).
